# EUROPÄISCHE PATENTSCHRIFT

(11) **EP 3 055 705 B1**
(45) Veröffentlichungstag und Bekanntmachung des Hinweises auf die Patenterteilung: **21.04.2021**
(21) Anmeldenummer: 14758534.3
(22) Anmeldetag: 29.08.2014
(51) Int. Cl.: G01R 31/28

(54) **VORRICHTUNG UND VERFAHREN ZUR ZUSTANDSERKENNUNG**
DEVICE AND METHOD FOR DETECTING A STATE
DISPOSITIF ET PROCÉDÉ POUR LA DÉTECTION D'UN ÉTAT

(30) Priorität: 10.10.2013 DE 102013220403
(43) Veröffentlichungstag der Anmeldung: 17.08.2016
(73) Patentinhaber: Robert Bosch GmbH, 70442 Stuttgart (DE)
(72) Erfinder: SCHEIERMANN, Sergej, 70565 Stuttgart (DE)
(86) Internationale Anmeldenummer: PCT/EP2014/068426
(87) Internationale Veröffentlichungsnummer: WO 2015/051948

(56) Entgegenhaltungen:
- EP-A2- 1 039 359
- EP-A2- 2 278 344
- DE-A1-102005 025 541
- DE-A1-102008 039 450
- DE-A1-102010 043 394
- JP-A- 2001 004 672
- JP-A- 2004 272 771
- US-A1- 2007 108 988

## Beschreibung

Die vorliegende Erfindung betrifft eine Vorrichtung und ein Verfahren zur Zustandserkennung. Insbesondere betrifft die vorliegende Erfindung eine Vorrichtung und ein Verfahren zur Zustandserkennung eines kabelgebundenen Elektrogerätes.

Die Vernetzung von Elektrogeräten innerhalb von Gebäuden gewinnt zunehmend an Bedeutung. Hierzu existieren beispielsweise bereits Systeme zur Überwachung von Raumtemperaturen, Luftfeuchtigkeit, Wasseraustritt, etc. Ferner sind auch bereits einige Anwendungen bekannt, bei denen Messdaten an ein Energieversorgungsunternehmen automatisch übertragen werden. Darüber hinaus existieren auch bereits einige Anwendungen, bei denen die Aktivität einer Person überwacht wird, indem die Geräteaktivität ausgewertet wird. Beispielsweise kann hierzu überwacht werden, ob ein Wasserkocher, eine Kaffeemaschine, eine Waschmaschine oder ähnliches regelmäßig in Betrieb genommen wird. Wird ein solches Gerät über längere Zeit nicht aktiviert, so liegt die Vermutung nahe, dass eine in diesem Haushalt lebende Person von ihren regelmäßigen Gepflogenheiten abweicht und deshalb gegebenenfalls externe Hilfe benötigt. Zur Überwachung der Aktivität der einzelnen Geräte können die Elektrogeräte beispielsweise mit einer Funkschnittstelle ausgerüstet werden, so dass die Geräte regelmäßig ihren aktuellen Zustand an eine zentrale Stelle übermitteln können.

Eine weitere Möglichkeit zur Überwachung der Aktivität eines Elektrogerätes besteht darin, ein zusätzliches Leistungsmessgerät zwischen Steckdose und Netzstecker des Elektrogerätes anzuordnen. Solche Geräte können erkennen, ob ein angeschlossenes Elektrogerät Energie aufnimmt, um daraus auf eine Aktivität des Elektrogeräts schließen.

Die Europäische Patentanmeldung EP 2 278 344 A2 offenbart einen drahtlosen Stromsensor zur indirekten Messung mittels Magnetfeldsensoren. Hierzu werden mehrere Magnetfeldsensoren um ein Energieversorgungskabel eines Elektrogerätes angeordnet. Diese Stromsensoren sind in einem Gehäuse angeordnet, das geöffnet werden kann, um den Stromsensor um die Energieversorgungsleitung des Elektrogerätes herum anzuordnen.

Es besteht daher ein Bedarf nach einer kostengünstigen und energieeffizienten Zustandserkennung für ein kabelgebundenes Elektrogerät. Ferner besteht ein Bedarf nach einer Zustandserkennung für ein kabelgebundenes Elektrogerät, das eine unkomplizierte Bedienbarkeit erlaubt und das einfach installiert und eingesetzt werden kann.

### Offenbarung der Erfindung

Hierzu schafft die vorliegende Erfindung gemäß einem ersten Aspekt eine Vorrichtung zur Zustandserkennung eines kabelgebundenen Elektrogeräts nach dem Anspruch 1.

Gemäß einem weiteren Aspekt schafft die vorliegende Erfindung ein Verfahren zur Zustandserkennung eines kabelgebundenen Elektrogeräts nach dem Anspruch 10.

### Vorteile der Erfindung

Es ist eine Idee der vorliegenden Erfindung, ein durch den Stromfluss in einer Zuleitung eines Elektrogerätes hervorgerufenes Magnetfeld durch einen Magnetfeldsensor an der Zuleitung zu erfassen und dieses erfasste Magnetfeld mit zuvor bestimmten Referenzwerten zu vergleichen, um hieraus auf den aktuellen Betriebszustand des Elektrogerätes zu schließen. Durch den Vergleich der erfassten Magnetfeldwerte mit zuvor bestimmten Referenzwerten kann auf besonders einfache Weise eine schnelle, einfache und somit auch kostengünstige Bestimmung des Zustands des Elektrogerätes erreicht werden. Da ein solcher Vergleich von erfassten Magnetfeldwerten mit Referenzwerten sehr zuverlässig erfolgen kann, müssen auch an den verwendeten Magnetfeldsensor keine hohen Ansprüche gestellt werden. Daher kann ein besonders kostengünstiger Magnetfeldsensor eingesetzt werden, was die Kosten des Gesamtsystems entsprechend verringert.

Ferner muss für die Bestimmung der Betriebszustände des Elektrogerätes auch nur aus einer zuvor vorgegebenen Anzahl von möglichen Zuständen ausgewählt werden. Da darüber hinaus keine weiteren Zwischenzustände erlaubt sind, wird die Zuverlässigkeit einer Zustandserkennung erhöht und die Gefahr von falsch erkannten Zuständen wird reduziert. Vorbestimmte Betriebszustände können beispielsweise die Betriebszustände "Ein" und "Aus" des Elektrogerätes sein. Darüber hinaus sind jedoch auch weitere Zustände möglich, soweit diese sich über eine charakteristische Leistungs- oder Stromaufnahme unterscheiden lassen.

In einer Ausführungsform umfasst die Vorrichtung zur Zustandserkennung ferner eine Kalibriervorrichtung, die dazu ausgelegt ist, für einen vorbestimmten Betriebszustand des Elektrogeräts aus dem von dem Magnetfeldsensor erfassten Magnetfeld einen Referenzwert zu bestimmen und den bestimmten Referenzwert zusammen mit dem korrespondierenden Zustand in dem Speicher abzuspeichern. Durch eine solche Kalibrierung der Zustandserkennung ist es möglich, die Zustandserkennung für jedes zu überwachende Elektrogerät individuell anzupassen. Insbesondere kann hierdurch die Zustandsüberwachung besonders einfach auf Geräte mit unterschiedlichen Leistungsaufnahmen angepasst werden, ohne dass hierfür eine Modifikation in der verwendeten Hardware erforderlich ist. Somit kann die Vorrichtung zur Zustandserkennung besonders universell eingesetzt werden.

In einer weiteren Ausführungsform ist die Kalibriervorrichtung dazu ausgelegt, die Referenzwerte in dem Speicher zu aktualisieren, wenn sich das Elektrogerät in einem bekannten Betriebszustand befindet und der korrespondierende abgespeicherte Referenzwert in dem Speicher von dem aktuell von dem Magnetfeldsensor erfassten Magnetfeld abweicht. Auf diese Weise können die Referenzwerte regelmäßig aktualisiert werden. Äußere Störungen und Beeinflussungen des Magnetfelds können somit rasch kompensiert werden, so dass stets eine zuverlässige Zustandserkennung möglich ist, selbst wenn sich beispielsweise das Magnetfeld am Magnetfeldsensor aufgrund von äußeren Einflüssen verändern würde.

In einer weiteren Ausführungsform umfasst die Kalibriervorrichtung eine Eingabevorrichtung, die dazu ausgelegt ist, eine Benutzereingabe zu empfangen, wobei die Kalibriervorrichtung dazu ausgelegt ist, einen Referenzwert zu bestimmen und den bestimmten Referenzwert zusammen mit einem korrespondierenden vorbestimmten Betriebszustand in dem Speicher abzulegen, nachdem die Eingabevorrichtung eine Benutzereingabe empfangen hat. Auf diese Weise ist eine besonders einfache manuelle Kalibrierung der Vorrichtung zur Zustandserkennung möglich.

Die Eingabevorrichtung kann beispielsweise auch mehrere Eingabeelemente aufweisen, wobei jedes dieser Eingabeelemente einem der vorbestimmten Betriebszustände zugeordnet ist. Auf diese Weise kann ein Benutzer, je nachdem welches dieser Eingabeelemente er betätigt, auch gleichzeitig signalisieren, in welchem Betriebszustand sich das zu überwachende Elektrogerät gerade befindet.

Die Vorrichtung umfasst ferner eine Befestigungsvorrichtung, die dazu ausgelegt ist, den Magnetfeldsensor an der elektrischen Zuleitung des Elektrogerätes anzuordnen, wobei ein Abstand zwischen Zuleitung des Elektrogeräts und Magnetfeldsensor anpassbar ist. Auf diese Weise kann einerseits der Magnetfeldsensor sicher an einer definierten Position in Bezug auf die Zuleitung des Elektrogerätes angeordnet werden, so dass das zu erfassende Magnetfeld zustandsabhängig sicher erfasst werden kann. Durch den anpassbaren Abstand zwischen Zuleitung und Magnetfeldsensor kann dabei der Magnetfeldsensor jeweils so in Bezug auf die Zuleitung angeordnet werden, dass der Magnetfeldsensor einen angepassten Teil des von der Zuleitung erzeugten Magnetfelds erfasst. Somit kann die Erfassung des Magnetfeldsensors auf die Intensität des auftretenden Magnetfelds abgestimmt werden. Der Magnetfeldsensor muss daher nur einen relativ geringen Erfassungsmessbereich aufweisen, wodurch der Einsatz relativ preiswerter Magnetfeldsensoren möglich wird. Handelt es sich bei dem zu überwachenden Elektrogerät um ein Elektrogerät mit einer relativ geringen Leistung, so wird an der elektrischen Zuleitung auch nur ein relativ geringes Magnetfeld auftreten. In diesem Fall kann der Magnetfeldsensor relativ dicht an der Zuleitung angeordnet werden. Wird dagegen ein Elektrogerät mit einer relativ großen elektrischen Leistung überwacht, so wird an der Zuleitung ein relativ großes Magnetfeld auftreten. In diesem Fall kann der Magnetfeldsensor weiter entfernt von der Zuleitung angeordnet werden und erfasst dabei nur einen relativ geringen Teil des Magnetfelds. Daher kann auch in diesem Fall ein einfacher Magnetfeldsensor für relativ schwache Magnetfelder eingesetzt werden.

In einer Ausführungsform weist die Befestigungsvorrichtung eine Skala auf, die eine Position des Magnetfeldsensors in Abhängigkeit von der Leistung des zu überwachenden Elektrogerätes anzeigt. Hierdurch kann ein Benutzer den Magnetfeldsensor sehr einfach an der Befestigungsvorrichtung justieren und somit einen optimalen Betriebspunkt einstellen.

In einer weiteren Ausführungsform handelt es sich bei dem Magnetfeldsensor um einen Magnetfeldsensor, der dazu ausgelegt ist, ein Magnetfeld an der Zuleitung des Elektrogerätes dreidimensional zu erfassen. Durch diese dreidimensionale Erfassung des Magnetfelds in alle drei Raumrichtungen kann eine besonders zuverlässige Erfassung des Magnetfelds erfolgen. Vorzugsweise wird dabei das Magnetfeld in alle drei Raumrichtungen, also in x-Richtung, y-Richtung und z-Richtung separat ausgewertet. In diesem Fall können in dem Speicher auch jeweils separate Referenzwerte für die entsprechenden Raumrichtungen abgelegt werden.

In einer weiteren Ausführungsform umfasst die Vorrichtung ferner eine Schnittstelle, die dazu ausgelegt ist, den von der Verarbeitungsvorrichtung bestimmten Zustand des Elektrogerätes an eine Empfangsvorrichtung zu übertragen. Vorzugsweise ist die Schnittstelle eine kabellose Funkschnittstelle. Durch eine solche Schnittstelle können die von der Vorrichtung ermittelten Betriebszustände für eine weitere Verarbeitung weitergeleitet werden. Hierdurch ist eine besonders effiziente Auswertung der von der Vorrichtung ermittelten Betriebszustände möglich.

In einer weiteren Ausführungsform ist die Schnittstelle ferner dazu ausgelegt, ein Kalibriersignal zu empfangen, wobei die Kalibriervorrichtung dazu ausgelegt ist, einen Referenzwert zu bestimmten und den bestimmten Referenzwert zusammen mit einem korrespondierenden vorbestimmten Betriebszustand des Elektrogeräts in dem Speicher abzuspeichern, nachdem die Schnittstelle ein Kalibriersignal empfangen hat. Auf diese Weise kann der Kalibriervorgang der Vorrichtung durch ein entsprechendes Übertragen von Kalibriersignalen von außen ferngesteuert werden.

Die vorliegende Erfindung schafft in einem weiteren Aspekt ferner ein Gebäudemanagementsystem mit einer erfindungsgemäßen Vorrichtung zur Zustandserkennung.

### Kurze Beschreibung der Zeichnungen

Weitere Ausführungsformen und Vorteile der vorliegenden Erfindung ergeben sich aus der nachfolgenden Beschreibung mit Bezug auf die beigefügten Zeichnungen. Dabei zeigen:
- Figur 1:: eine schematische Darstellung einer Vorrichtung zur Zustandserkennung eines kabelgebundenen Elektrogeräts gemäß einem Ausführungsbeispiel;
- Figur 2:: eine schematische Darstellung einer Vorrichtung zur Zustandserkennung eines kabelgebundenen Elektrogeräts gemäß einem weiteren Ausführungsbeispiel;
- Figur 3:: eine schematische Darstellung von Anwendungsbeispielen einer Vorrichtung zur Zustandserkennung gemäß einem weiteren Ausführungsbeispiel; und
- Figur 4:: eine schematische Darstellung eines Ablaufdiagramms für ein Verfahren zur Zustandserkennung, wie es einem weiteren Ausführungsbeispiel zugrunde liegt.

### Beschreibung von Ausführungsbeispielen

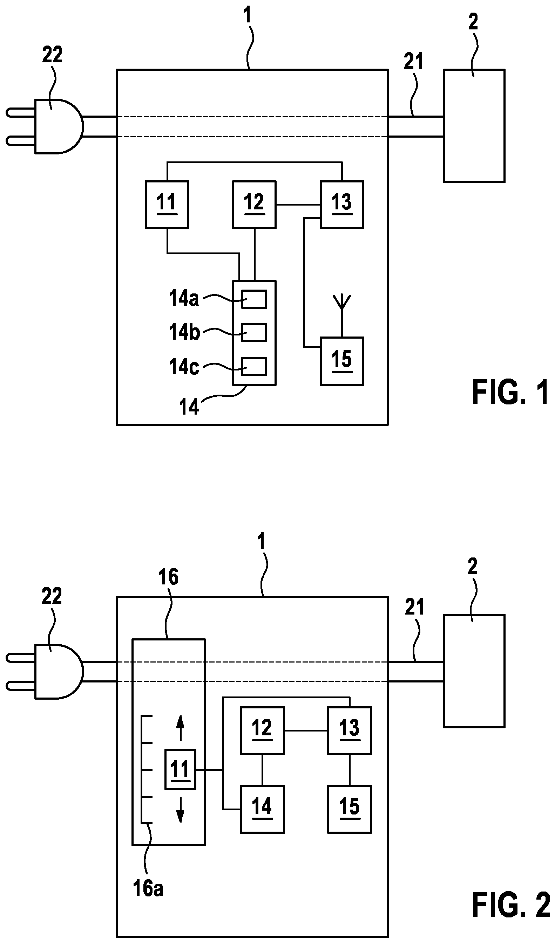

Figur 1 zeigt eine schematische Darstellung einer Vorrichtung 1 zur Zustandsüberwachung eines kabelgebundenen Elektrogeräts 2. Das kabelgebundene Elektrogerät 2 wird dabei über eine Zuleitung 21 mit elektrischer Energie versorgt. Beispielsweise kann die Zuleitung 21 hierzu über einen Stecker 22 verfügen, wobei mittels des Steckers 22 das Elektrogerät mit einer entsprechenden Steckdose verbunden werden kann. An der Zuleitung 21 zwischen Stecker 22 und Elektrogerät 2 ist dabei eine Vorrichtung 1 zur Zustandserkennung angebracht. Vorzugsweise umschließt dabei das Gehäuse der Vorrichtung 1 der Zustandserkennung einen Umfang der Zuleitung 21 entlang eines Abschnittes vollständig. Beispielsweise kann das Gehäuse der Vorrichtung 1 zur Zustandserkennung hierzu als eine Art Klammer oder ähnliches ausgebildet sein. Weitere Ausgestaltungsformen des Gehäuses sind darüber hinaus ebenso möglich. Beispielsweise kann die Vorrichtung 1 zur Zustandserkennung auch zweiteilig ausgeführt sein, wobei die beiden Teile mittels einer Klemmverbindung, Schraubverbindung oder ähnlichen Verbindung miteinander verbunden werden.

Die Vorrichtung 1 zur Zustandserkennung umfasst einen Magnetfeldsensor 11, einen Speicher 12, eine Verarbeitungsvorrichtung 13, eine Kalibriervorrichtung 14 und eine Schnittstelle 15.

Ist das Elektrogerät 2 aktiv und wird dabei über die Zuleitung 21 mit elektrischer Energie versorgt, so entsteht entlang der Zuleitung 21 ein Magnetfeld. Dieses Magnetfeld wird von dem Magnetfeldsensor 11 erfasst und ein zu dem erfassten Magnetfeld korrespondierendes Signal wird an die Verarbeitungsvorrichtung 13 weitergeleitet. Vorzugsweise handelt es sich bei dem Magnetfeldsensor 11 um einen Magnetfeldsensor, der das zu erfassende Magnetfeld dreidimensional erfasst. Ein solcher Magnetfeldsensor 13 erfasst somit Magnetfeldkomponenten in alle drei Raumrichtungen, also in x-Richtung, y-Richtung und z-Richtung. Diese einzelnen erfassten Magnetfeldkomponenten können auch separat der Verarbeitungsvorrichtung 13 zugeführt werden.

In dem Speicher 12 sind für jeden der möglichen vorbestimmten Betriebszustände des Elektrogeräts 2 jeweils Referenzwerte für ein korrespondierendes Magnetfeld abgespeichert. Die vorbestimmten Betriebszustände des Elektrogeräts 2 können beispielsweise die Betriebszustände "Ein" oder "Aus" sein. Darüber hinaus sind auch noch weitere Betriebszustände möglich, soweit sich diese über eine charakteristische Leistungsaufnahme des Elektrogeräts 2 bestimmen lassen. Dabei kann ein einer Ausführungsform beispielsweise der Betrag der aktuellen Leistungs- oder Stromaufnahme aus dem resultierenden Magnetfeld um die Zuleitung 21 bestimmt werden. Somit kann zum Beispiel festgestellt werden, ob ein Fön oder ein Heizlüfter mit reduzierter Leistung oder mit voller Leistung betrieben wird.

Alternativ ist es auch möglich, Schwankungen und Variationen in der Leistungsaufnahme des Elektrogeräts über die Zeit auszuwerten und hieraus auf einem bestimmten Betriebszustand zu schließen. Hierbei können in dem Speicher 12 auch entsprechende Referenzprofile abgelegt werden, die mit dem von dem Magnetfeldsensor 11 erfassten Verlauf verglichen werden können.

Handelt es sich bei dem Magnetfeldsensor 11 um einen dreidimensional erfassenden Magnetfeldsensor, so können ferner für jede der Raumrichtungen separat Referenzwerte abgespeichert werden.

Die Verarbeitungsvorrichtung 13 liest die in dem Speicher 12 abgespeicherten Referenzwerte aus und vergleicht diese mit dem von dem Magnetfeldsensor 11 erfassten Magnetfeld. Bei der Verarbeitungsvorrichtung 13 kann es sich zum Beispiel um einem entsprechend ausgestalteten Mikroprozessor handeln. Basierend auf dem Ergebnis des Vergleichs bestimmt die Verarbeitungsvorrichtung 13 einen aktuellen Betriebszustand des zu überwachenden Elektrogeräts 2. Dabei wird vorzugsweise durch die Verarbeitungsvorrichtung 13 der Betriebszustände aus der Menge der vorbestimmten Betriebszustände, die in dem Speicher 12 abgelegt sind, ausgewählt, der mit dem aktuell erfassten Magnetfeld durch den Magnetfeldsensor die größte Übereinstimmung aufweist. Dabei kann das von dem Magnetfeldsensor 11 überwachte Magnetfeld entweder nach Amplitude, Frequenz, Abstand zu harmonischen Schwingungen, Störungsamplituden, etc. überwacht und mit entsprechenden Referenzwerten verglichen werden. Auch eine entsprechende Auswertung von durch einen dreidimensional erfassten Magnetfeldsensor generierten Magnetfeldvektoren im Raum ist möglich.

Die Auswertung der Betriebszustände des zu überwachenden Elektrogeräts 2 kann dabei beispielsweise periodisch erfolgen. Hierzu können zum Beispiel im Abstand von vorbestimmten Zeitintervallen jeweils das Magnetfeld um die Zuleitung 21 durch den Magnetfeldsensor 11 erfasst werden und daraufhin der aktuelle Betriebszustände des zu überwachenden Elektrogerätes 2 bestimmt werden. Alternativ ist es auch möglich, dass nur bei einer Änderung des von dem Magnetfeldsensor 11 überwachten Magnetfelds eine Neubestimmung des aktuellen Betriebszustands des Elektrogeräts 2 erfolgt. Beispielsweise kann hierbei stets dann eine Neubestimmung des aktuellen Betriebszustands erfolgen, wenn sich das Magnetfeld insgesamt, oder zumindest eine Komponente des Magnetfelds um mehr als einen bestimmten Schwellwert verändert. Darüber hinaus sind ebenso weitere ereignisgesteuerte Betriebszustandsbestimmungen möglich.

Die von der Verarbeitungsvorrichtung 13 bestimmten Zustände werden an eine Schnittstelle 15 weitergeleitet. Die Schnittstelle 15 überträgt den von der Verarbeitungsvorrichtung 13 empfangenen Zustand an eine Gegenstelle. Beispielsweise kann es sich bei dieser Gegenstelle um eine zentrale Überwachungs- oder Speichereinheit eines Gebäudemanagementsystems handeln. Auch weitere Gegenstelle, beispielsweise eine zentrale Verarbeitungseinrichtung an einem entfernten Ort sind möglich. Vorzugsweise handelt es sich bei der Schnittstelle 15 um eine kabellose Funkschnittstelle, die die von der Verarbeitungseinrichtung 13 bestimmten Zustände des Elektrogeräts 2 über eine Funkverbindung an die Gegenstelle übermittelt. Eine solche Funkverbindung kann beispielsweise eine WLAN-Verbindung, eine Bluetooth-Verbindung, eine DECT-Verbindung oder eine weitere Verbindung nach einem bekannten, standardisierten Format, oder eine proprietäre Kommunikationsverbindung sein.

Die Gegenstelle kann über eine geeignete Anzeigevorrichtung verfügen, an der die aktuell empfangenen Zustände der zu überwachenden Geräte angezeigt werden. Zusätzlich oder alternativ kann die Gegenstelle auch über eine weitere Kommunikationsschnittstelle verfügen, über die ein Benutzer die Überwachungsergebnisse von einem entfernten Ort aus empfangen kann. Beispielsweis kann ein Benutzer über ein Smartphone oder einen Computer, z.B. einen Tablet-PC, mit der Gegenstelle in Kontakt treten, um Informationen über die Zustände der überwachten Elektrogeräte zu erhalten.

Um die Referenzwerte in dem Speicher 12 erstmalig zu bestimmen oder gegebenenfalls zu aktualisieren, kann die Vorrichtung 1 zur Zustandserkennung die Referenzwerte in dem Speicher 12 aktualisieren. Hierzu verfügt die Vorrichtung 1 zur Zustandserkennung über eine entsprechende Kalibriervorrichtung 14. Diese Kalibriervorrichtung 14 generiert basiert auf dem von dem Magnetfeldsensor 11 aktuell erfassten Magnetfeld entsprechende Referenzwerte und speichert diese zusammen mit einem entsprechenden korrespondierenden Zustand in dem Speicher 12 ab. Dieser Kalibriervorgang kann entweder manuell oder automatisch erfolgen.

Beispielsweise kann die Kalibriervorrichtung 14 die von dem Magnetfeldsensor 11 bereitgestellten Magnetfeldwerte regelmäßig auswerten und mit dem aktuellen Zustand des zu überwachenden Elektrogeräts 2 vergleichen. Weichen dabei die aktuellen Messwerte des Magnetfeldsensors 11 von den Referenzwerten in dem Speicher 12 ab, so kann die Kalibriervorrichtung 14 entsprechend neue Referenzwerte generieren und diese in dem Speicher 12 ablegen. Beispielsweise kann eine solche Aktualisierung der Referenzwerte erfolgen, wenn die Referenzwerte in dem Speicher 12 von den aktuell ermittelten Werten durch die Kalibriervorrichtung 14 um mehr als einen vorbestimmten Schwellwert abweichen.

Alternativ ist auch eine manuelle Kalibrierung möglich. Hierzu kann die Kalibriervorrichtung 14 über einen oder mehrere Eingabevorrichtungen 14a, 14b und 14c verfügen. Jede dieser Eingabevorrichtungen 14a, 14b, 14c kann dabei einem vorbestimmten Betriebszustand des zu überwachenden Elektrogeräts zugeordnet sein. Zur Kalibrierung bringt ein Benutzer das zu überwachende Elektrogerät 2 in einen der vorbestimmten Betriebszustände und betätigt daraufhin die dazugehörige Eingabevorrichtung 14a, 14b oder 14c. Daraufhin wertet die Kalibriervorrichtung 14 das von dem Magnetfeldsensor 11 erfasste Magnetfeld aus, generiert entsprechende Referenzwerte und speichert diese zusammen mit einer Angabe über den korrespondierenden vorbestimmten Betriebszustand in dem Speicher 12 ab. Dieser Vorgang kann für jeden der vorbestimmten Betriebszustände separat ausgeführt werden. Nachdem der Kalibriervorgang für alle zu erkennenden vorbestimmten Zustände durchgeführt wurde, sind alle erforderlichen Referenzwerte in dem Speicher 12 abgespeichert und die Vorrichtung 1 zur Zustandserkennung kann daraufhin eine zuverlässige Erkennung der Betriebszustände des Elektrogeräts 2 ausführen.

Alternativ kann auch über die Schnittstelle 15 von der Gegenstelle ein entsprechendes Kalibriersignal an die Vorrichtung 1 zur Zustandserkennung übertragen werden und daraufhin die Kalibriervorrichtung 14 eine Kalibrierung entsprechend dem zuvor beschriebenen manuellen Konzept ausführen. Vorzugsweise enthält dabei das von der Schnittstelle 15 empfangene Kalibriersignal jeweils eine Angabe über einen entsprechenden vorbestimmten Betriebszustand. Die Gegenstelle, von der das Kalibriersignal an die Schnittstelle 15 übertragen wird, kann darüber hinaus über eine weitere Vorrichtung verfügen, die dem Benutzer während des Kalibriervorgangs jeweils einen Hinweis darauf gibt, in welchen Betriebszustand er das zu überwachende Elektrogerät 2 bringen muss.

Figur 2 zeigt eine weitere schematische Darstellung einer Vorrichtung 1 zur Zustandserkennung eines kabelgebundenen Elektrogeräts 2 gemäß einer weiteren Ausführungsform. Die Vorrichtung 1 zur Zustandserkennung dieser Ausführungsform ist dabei weitestgehend identisch mit der Vorrichtung 1 zur Zustandserkennung des zuvor beschriebenen Ausführungsbeispiels. In diesem Fall verfügt die Vorrichtung 1 zur Zustandserkennung jedoch weiterhin über eine Befestigungsvorrichtung 16, die es ermöglicht, den Magnetfeldsensor 11 in einem variablen Abstand von der Zuleitung 21 anzubringen. Durch die Variation des Abstands zwischen Magnetfeldsensor 11 und Zuleitung 21 kann dabei das von dem Magnetfeldsensor 11 erfasste Magnetfeld so angepasst werden, dass es auf den verwendeten Typ eines Magnetfeldsensors 11 zugeschnitten ist. Hierdurch können Magnetfeldsensoren eingesetzt werden, die nur einen relativ geringen Messbereich für ein zu erfassendes Magnetfeld aufweisen. Wird der Magnetfeldsensor 11 dabei nahe an der Zuleitung 21 angeordnet, so erfasst der Magnetfeldsensor 11 einen Großteil des erzeugten Magnetfelds. Somit können auch bei zu überwachenden Elektrogeräten 2 mit einer relativ geringen Leistung zuverlässig die Betriebszustände des Elektrogeräts 2 erkannt werden. Hat das zu überwachende Elektrogerät 2 dagegen eine relativ große Leistungsaufnahme, so entstehen entlang der Zuleitung 21 relativ große Magnetfelder. Um dabei den Magnetfeldsensor 11 nicht zu übersteuern, kann der Magnetfeldsensor 11 weiter entfernt von der Zuleitung 21 angeordnet werden.

Die Befestigungsvorrichtung 16 für den Magnetfeldsensor 11 kann dabei beispielsweise über eine Skala 16a verfügen, die einem Benutzer einen Hinweis darauf gibt, an welcher Position in Abhängigkeit von der Leistung eines zu überwachenden Elektrogeräts er den Magnetfeldsensor 11 positionieren soll. Die Position des Magnetfeldsensors 11 kann dabei entweder kontinuierlich zwischen einer minimalen und einer maximalen Entfernung eingestellt werden. Alternativ ist auch ein Einstellen der Position in zwei oder mehreren definierten Schritten möglich.

Zur weiteren Anpassung des Messbereichs des verwendeten Magnetfeldsensors 11 an das entlang der Zuleitung 21 entstehende Magnetfeld kann die Vorrichtung 1 zur Zustandserkennung ferner noch über einen Flusskonzentrator (nicht dargestellt) verfügen, der das entlang der Zuleitung 21 entstehende Magnetfeld in Bezug auf den eingesetzten Magnetfeldsensor 11 konzentriert oder aufweitet. Dabei kann auch ein solcher Flusskonzentrator so innerhalb der Vorrichtung 1 zur Zustandserkennung angeordnet werden, dass ein Benutzer manuell den Flusskonzentrator so anpassen kann, dass eine Anpassung in Abhängigkeit von einem zu erwartenden Magnetfeld eingestellt werden kann.

Zur weiteren Erhöhung der Zuverlässigkeit können anstelle eines einzigen Magnetfeldsensors 11 auch mehrere Magnetfeldsensoren 11 eingesetzt werden, die beispielsweise symmetrisch um die Zuleitung 21 angeordnet werden.

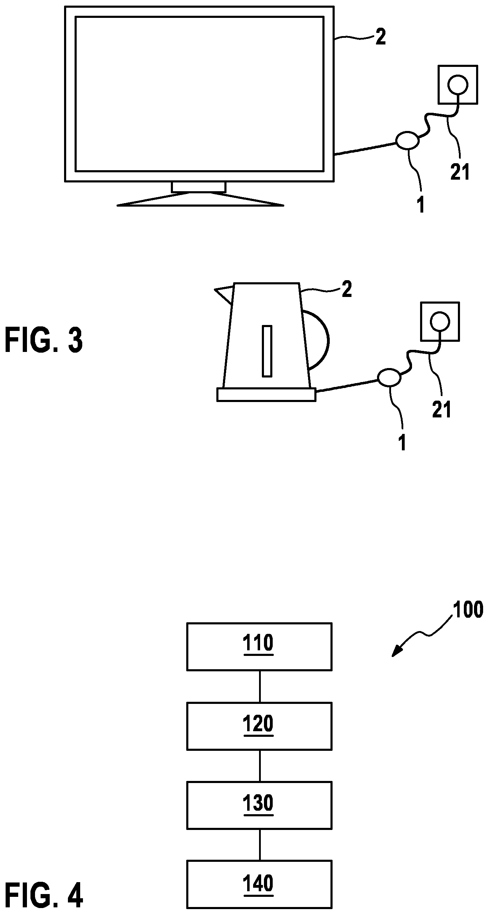

Figur 3 zeigt eine schematische Darstellung von Anwendungsfällen für eine Vorrichtung 1 zur Zustandserkennung von Elektrogeräten 2. Wie aus Figur 3 zu erkennen ist, kann es sich bei den zu überwachenden Elektrogeräten 2 um beliebige Elektrogeräte handeln. Beispielsweise kann es sich bei den Elektrogeräten 2 um einen TV-Gerät oder einen Wasserkocher handeln. Ein Bügeleisen, eine Waschmaschine, eine Leuchte oder andere Elektrogeräte sind ebenso möglich.

Figur 4 zeigt eine schematische Darstellung eines Ablaufdiagramms für ein Verfahren 100 zur Zustandserkennung eines kabelgebundenen Elektrogeräts 2, wie es einer Ausführungsform der vorliegenden Erfindung zugrunde liegt. In einem Schritt 110 wird ein Magnetfeld an der elektrischen Zuleitung 21 eines Elektrogeräts 2 erfasst. Ferner werden in Schritt 120 Referenzwerte für eine Mehrzahl von vorbestimmten Betriebszuständen des Elektrogeräts 2 bereitgestellt. In Schritt 130 wird das von dem Magnetfeldsensor 11 erfasste Magnetfeld mit den bereitgestellten Referenzwerten verglichen. Schließlich wird in Schritt 140 basierend auf diesem Vergleich ein Betriebszustand des Elektrogeräts 2 bestimmt.

Zusammenfassend betrifft die vorliegende Erfindung eine Vorrichtung und ein Verfahren zur Zustandserkennung eines Elektrogeräts. Dabei wird entlang einer elektrischen Zuleitung des Elektrogeräts, über die das Elektrogerät mit Energie versorgt wird, mittels eines Magnetfeldsensors ein Magnetfeld erfasst und das so erfasste Magnetfeld mit zuvor bestimmten Referenzwerten verglichen, um den Betriebszustand des Elektrogeräts zu bestimmen. Die Bestimmung der Referenzwerte kann dabei in einem vorgelagerten Kalibrierungsprozess individuell auf das zu überwachende Elektrogerät abgestimmt werden.

## Patentansprüche

1. Vorrichtung (1) zur Zustandsüberwachung eines kabelgebundenen Elektrogeräts (2), mit:
einem Magnetfeldsensor (11), der dazu ausgelegt ist, ein Magnetfeld an einer elektrischen Zuleitung (21) des Elektrogeräts (2) zu erfassen;
einem Speicher (12), der dazu ausgelegt ist, für eine Mehrzahl von vorbestimmten Betriebszuständen des Elektrogeräts (2) jeweils Referenzwerte für ein korrespondierendes Magnetfeld abzuspeichern;
einer Verarbeitungsvorrichtung (13), die dazu ausgelegt ist, das von dem Magnetfeldsensor (11) erfassten Magnetfeld mit den im Speicher (12) abgespeicherten Referenzwerten zu vergleichen und basierend auf dem Vergleich einen Betriebszustand des Elektrogeräts (2) zu bestimmen; **gekennzeichnet durch**
eine Befestigungsvorrichtung (16), die dazu ausgelegt ist, den Magnetfeldsensor (11) an der Zuleitung (21) des Elektrogeräts (2) anzuordnen, wobei ein Abstand zwischen Zuleitung (21) des Elektrogeräts (2) und Magnetfeldsensor (11) in einer Mehrzahl von definierten Schritten oder kontinuierlich zwischen einer minimalen und einer maximalen Entfernung einstellbar ist.

2. Vorrichtung (1) nach Anspruch 1, mit einer Kalibriervorrichtung (14), die dazu ausgelegt ist, für einen vorbestimmten Betriebszustand des Elektrogeräts (2) aus dem von dem Magnetsensor (11) erfassten Magnetfeld einen Referenzwert zu bestimmen und den bestimmten Referenzwert zusammen mit dem korrespondierenden vorbestimmten Zustand in dem Speicher (12) abzuspeichern.

3. Vorrichtung (1) nach Anspruch 2, wobei die Kalibriervorrichtung (14) dazu ausgelegt ist, die Referenzwerte in dem Speicher (12) zu aktualisieren, wenn sich das Elektrogerät (2) in einem bekannten vorbestimmten Betriebszustand befindet und der korrespondierende abgespeicherte Referenzwert in dem Speicher (12) von dem aktuell von dem Magnetfeldsensor (11) erfassten Magnetfeld abweicht.

4. Vorrichtung (1) nach Anspruch 2 oder 3, mit einer Eingabevorrichtung (14a, 14b, 14c), die dazu ausgelegt ist, eine Benutzereingabe zu empfangen; wobei die Kalibriervorrichtung (14) dazu ausgelegt ist, einen Referenzwert zu bestimmen und den bestimmten Referenzwert zusammen mit einem korrespondierenden vorbestimmten Betriebszustand in dem Speicher (12) abzuspeichern, nachdem die Eingabevorrichtung (14a, 14b, 14c) eine Benutzereingabe empfangen hat.

5. Vorrichtung (1) nach einem der Ansprüche 1 bis 4, mit einem Flusskonzentrator, der dazu ausgelegt ist, ein entlang der Zuleitung (21) entstehendes Magnetfeld in Bezug auf den Magnetfeldsensor (11) zu konzentrieren oder aufzuweiten.

6. Vorrichtung (1) nach einem der Ansprüche 1 bis 5, wobei der Magnetfeldsensor (11), die dazu ausgelegt ist, ein Magnetfeld an der Zuleitung (21) des Elektrogeräts (2) dreidimensional zu erfassen.

7. Vorrichtung (1) nach einem der Ansprüche 1 bis 6, mit einer Schnittstelle (15) die dazu ausgelegt ist, den von der Verarbeitungsvorrichtung (13) bestimmten Betriebszustand des Elektrogeräts (2) an eine Empfangsvorrichtung zu übertragen.

8. Vorrichtung (1) nach Anspruch 7, wobei die Schnittstelle (15) ferner dazu ausgelegt ist, ein Kalibriersignal zu empfangen, wobei die Kalibriervorrichtung (14) dazu ausgelegt ist, einen Referenzwert zu bestimmen und den bestimmten Referenzwert zusammen mit einem korrespondierenden vorbestimmten Betriebszustand in dem Speicher (12) abzuspeichern, nachdem die Schnittstelle (15) ein Kalibriersignal empfangen hat.

9. Gebäudemanagementsystem mit einer Vorrichtung (1) nach einem der Ansprüche 1 bis 8.

10. Verfahren (100) zur Zustandsüberwachung eines kabelgebundenen Elektrogeräts (2), mit den Schritten:
Anordnen eines Magnetfeldsensors (11) an der Zuleitung (21) des Elektrogeräts (2), wobei der Abstand zwischen Zuleitung (21) des Elektrogeräts (2) und Magnetfeldsensor (11) in einer Mehrzahl von definierten Schritten oder kontinuierlich zwischen einer minimalen und einer maximalen Entfernung einstellbar ist;
Erfassen (110) eines Magnetfelds an einer elektrischen Zuleitung (21) des Elektrogeräts (2) mittels des Magnetfeldsensors (11);
Bereitstellen (120) von Referenzwerten für eine Mehrzahl von vorbestimmten Betriebszuständen des Elektrogeräts (2);
Vergleichen (130) des von dem Magnetfeldsensor (11) erfassten Magnetfelds mit den bereitgestellten Referenzwerten; und
Bestimmen (140) eines Betriebszustands des Elektrogeräts (2) basierend auf dem Vergleich.

## Claims

1. Device (1) for monitoring the state of a cable bound electric device (2), having:
a magnetic field sensor (11) which is configured to sense a magnetic field at an electrical feedline (21) of the electrical device (2);
a memory (12) which is configured to store, for a multiplicity of predetermined operating states of the electrical device (2), respective reference values for a corresponding magnetic field;
a processing device (13) which is configured to compare the magnetic field sensed by the magnetic field sensor (11), with reference values which is stored in the memory (12), and to determine an operating state of the electrical device (2) on the basis of the comparison, **characterized by**
an attachment device (16) which is configured to arrange the magnetic field sensor (11) on the feedline (21) of the electrical device (2), wherein a distance between the feedline (21) of the electrical device (2) and the magnetic field sensor (11) can be set in a multiplicity of defined increments or continuously between a minimum and a maximum distance.

2. Device (1) according to Claim 1, having a calibration device (14) which is configured to determine a reference value for a predetermined operating state of the electrical device (2) from the magnetic field which is sensed by the magnetic sensor (11) and to store the determined reference value together with the corresponding predetermined state in the memory (12).

3. Device (1) according to Claim 2, wherein the calibration device (14) is configured to update the reference values in the memory (12) when the electrical device (2) is in a known predetermined operating state, and the corresponding stored reference value in the memory (12) differs from the magnetic field which is currently sensed by the magnetic field sensor (11).

4. Device (1) according to Claim 2 or 3, having an input device (14a, 14b, 14c) which is configured to receive a user input; wherein the calibration device (14) is configured to determine a reference value, and to store the determined reference value together with a corresponding predetermined operating state in the memory (12), after the input device (14a, 14b, 14c) has received a user input.

5. Device (1) according to one of Claims 1 to 4, having a flux concentrator which is configured to concentrate or expand the magnetic field, arising along the feedline (21), with respect to the magnetic field sensor (11).

6. Device (1) according to one of Claims 1 to 5, wherein the magnetic field sensor (11) which is configured to sense a magnetic field at the feedline (21) of the electrical device (2) in a three-dimensional fashion.

7. Device (1) according to one of Claims 1 to 6, having an interface (15) which is configured to transmit the operating state, determined by the processing device (13), of the electrical device (2) to a receiver device.

8. Device (1) according to Claim 7, wherein the interface (15) is also configured to receive a calibration signal, wherein the calibration device (14) is configured to determine a reference value and to store the determined reference value together with a corresponding predetermined operating state in the memory (12), after the interface (15) has received the calibration state.

9. Building management system having a device (1) according to one of Claims 1 to 8.

10. Method (100) for monitoring the state of a cable-bound electrical device (2), comprising the steps:
arrangement of a magnetic field sensor (11) on the feedline (21) of the electrical device (2), wherein the distance between the feedline (21) of the electrical device (2) and the magnetic field sensor (11) can be set in a multiplicity of defined increments or continuously between a minimum and a maximum distance;
sensing (110) a magnetic field at an electrical feedline (21) of the electrical device (2) by means of a magnetic field sensor (11);
making available (120) reference values for a multiplicity of predetermined operating states of the electrical device (2);
comparing (130) the magnetic field sensed by the magnetic field sensor (11) with the reference values which are made available; and
determining (140) an operating state of the electrical device (2) on the basis of the comparison.

## Revendications

1. Dispositif (1) de surveillance d'état d'un appareil électrique câblé (2), comprenant :
un capteur de champ magnétique (11) qui est conçu pour détecter un champ magnétique sur un câble d'alimentation électrique (21) de l'appareil électrique (2) ;
une mémoire (12) qui est conçue pour stocker pour une pluralité d'états de fonctionnement prédéterminés de l'appareil électrique (2) respectivement des valeurs de référence pour un champ magnétique correspondant ;
un dispositif de traitement (13) qui est conçu pour comparer le champ magnétique détecté par le capteur de champ magnétique (11) avec les valeurs de référence stockées dans la mémoire (12) et pour déterminer sur la base de la comparaison un état de fonctionnement de l'appareil électrique (2) ; **caractérisé par**
un dispositif de fixation (16) qui est conçu pour disposer le capteur de champ magnétique (11) sur le câble d'alimentation (21) de l'appareil électrique (2), une distance entre le câble d'alimentation (21) de l'appareil électrique (2) et le capteur de champ magnétique (11) étant réglable en une pluralité d'incréments définis ou en continu entre une distance minimale et une distance maximale.

2. Dispositif (1) selon la revendication 1, comprenant un dispositif d'étalonnage (14) qui est conçu pour déterminer pour un état de fonctionnement prédéterminé de l'appareil électrique (2), à partir du champ magnétique détecté par le capteur magnétique (11), une valeur de référence et pour stocker dans la mémoire (12) la valeur de référence déterminée conjointement avec l'état prédéterminé correspondant.

3. Dispositif (1) selon la revendication 2, le dispositif d'étalonnage (14) étant conçu pour mettre à jour les valeurs de référence dans la mémoire (12) si l'appareil électrique (2) se trouve dans un état de fonctionnement prédéterminé connu et la valeur de référence mémorisée correspondante dans la mémoire (12) s'écarte du champ magnétique détecté actuellement par le capteur de champ magnétique (11).

4. Dispositif (1) selon la revendication 2 ou 3, comprenant un dispositif d'entrée (14a, 14b, 14c) qui est conçu pour recevoir une entrée utilisateur ; le dispositif d'étalonnage (14) étant conçu pour déterminer une valeur de référence et pour stocker dans la mémoire (12) la valeur de référence déterminée conjointement avec un état de fonctionnement prédéterminé correspondant après que le dispositif d'entrée (14a, 14b, 14c) a reçu une entrée utilisateur.

5. Dispositif (1) selon l'une quelconque des revendications 1 à 4, comprenant un concentrateur de flux qui est conçu pour concentrer ou élargir un champ magnétique qui se forme le long du câble d'alimentation (21) par rapport au capteur de champ magnétique (11).

6. Dispositif (1) selon l'une quelconque des revendications 1 à 5, le capteur de champ magnétique (11) étant conçu pour détecter en trois dimensions un champ magnétique sur le câble d'alimentation (21) de l'appareil électrique (2).

7. Dispositif (1) selon l'une quelconque des revendications 1 à 6, comprenant une interface (15) qui est conçue pour transmettre à un dispositif de réception l'état de fonctionnement de l'appareil électrique (2) déterminé par le dispositif de traitement (13).

8. Dispositif (1) selon la revendication 7, l'interface (15) étant en outre conçue pour recevoir un signal d'étalonnage, le dispositif d'étalonnage (14) étant conçu pour déterminer une valeur de référence et pour stocker dans la mémoire (12) la valeur de référence déterminée conjointement avec un état de fonctionnement prédéterminé correspondant après que l'interface (15) a reçu un signal d'étalonnage.

9. Système de gestion de bâtiment comprenant un dispositif (1) selon l'une quelconque des revendications 1 à 8.

10. Procédé (100) de surveillance d'état d'un appareil électrique câblé (2), comprenant les étapes consistant à :
disposer un capteur de champ magnétique (11) sur le câble d'alimentation (21) de l'appareil électrique (2), la distance entre le câble d'alimentation (21) de l'appareil électrique (2) et le capteur de champ magnétique (11) étant réglable en une pluralité d'incréments définis ou en continu entre une distance minimale et une distance maximale ;
détecter (110) un champ magnétique sur un câble d'alimentation électrique (21) de l'appareil électrique (2) au moyen du capteur de champ magnétique (11) ;
fournir (120) des valeurs de référence pour une pluralité d'états de fonctionnement prédéterminés de l'appareil électrique (2) ;
comparer (130) le champ magnétique détecté par le capteur de champ magnétique (11) avec les valeurs de référence fournies ; et
déterminer (140) un état de fonctionnement de l'appareil électrique (2) sur la base de la comparaison.
